# FASCICULE DE BREVET EUROPEEN

(11) **EP 2 521 162 B1**
(45) Date de publication et mention de la délivrance du brevet: **09.01.2019**
(21) Numéro de dépôt: 12166898.2
(22) Date de dépôt: 04.05.2012
(51) Int. Cl.: H01L 21/02, H01L 29/06, H01L 29/12, H01L 29/76, H01L 21/334, B82Y 40/00, B82Y 10/00, B82Y 30/00

(54) **Procédé de réalisation de nanocristaux de semi-conducteur orientés selon une direction pré-définie**
Verfahren zur Herstellung von Halbleiter-Nanokristallen, die nach einer vordefinierten Richtung ausgerichtet sind
Method for producing semiconductor nanocrystals oriented in a pre-defined direction

(30) Priorité: 06.05.2011 FR 1153926
(43) Date de publication de la demande: 07.11.2012
(73) Titulaire: Commissariat à l'Énergie Atomique et aux Énergies Alternatives, 75015 Paris (FR); Centre National de la Recherche Scientifique, 75016 Paris (FR)
(72) Inventeur: Borowik, Lukasz, 38360 Sassenage (FR); Barbe, Jean-Charles, 38160 Izeron (FR); Bussmann, Ezra, Caballo, NM 87931 (US); Cheynis, Fabien, 13010 Marseille (FR); Leroy, Frédéric, 13013 Marseille (FR); Mariolle, Denis, 38100 Grenoble (FR); Müller, Pierre, 13008 Marseille (FR)
(74) Mandataire: Ilgart, Jean-Christophe

(56) Documents cités:
- EP-A1- 1 615 271
- US-A- 6 090 666
- US-A1- 2005 136 655
- CAPELLINI G ET AL: "Agglomeration process in thin silicon-, strained silicon-, and silicon germanium-on-insulator substrates", JOURNAL OF APPLIED PHYSICS, AMERICAN INSTITUTE OF PHYSICS. NEW YORK, US, vol. 105, no. 9, 12 mai 2009 (2009-05-12), pages 93525-93525, XP012125117, ISSN: 0021-8979, DOI: 10.1063/1.3117837
- DANIELSON DAVID ET AL: "Surface-energy-driven dewetting theory of silicon-on-insulator agglomeration", JOURNAL OF APPLIED PHYSICS, AMERICAN INSTITUTE OF PHYSICS. NEW YORK, US, vol. 100, no. 8, 20 octobre 2006 (2006-10-20), pages 83507-083507, XP012090275, ISSN: 0021-8979, DOI: 10.1063/1.2357345
- IKEDA H ET AL: "In-situ observation of formation process of self-assembled Si islands on buried SiO2 and their crystallographic structures", MICROPROCESSES AND NANOTECHNOLOGY CONFERENCE, 2003. DIGEST OF PAPERS. 2003 INTERNATIONAL OCT. 29-31, 2003, PISCATAWAY, NJ, USA,IEEE, 29 octobre 2003 (2003-10-29), pages 18-19, XP010684342, DOI: 10.1109/IMNC.2003.1268497 ISBN: 978-4-89114-040-3

## Description

### DOMAINE TECHNIQUE

L'invention concerne un procédé de réalisation de nanocristaux de semi-conducteur obtenus par démouillage d'une couche mince de ce semi-conducteur disposée sur une couche diélectrique, orientés selon une direction choisie à l'avance et pouvant être utilisés pour la réalisation de dispositifs microélectroniques et/ou nanoélectroniques, par exemple des dispositifs mémoire.

L'invention concerne également un procédé de réalisation d'une couche diélectrique poreuse faisant appel à des nanocristaux de semi-conducteur orientés selon une direction pré-définie.

### ÉTAT DE LA TECHNIQUE ANTÉRIEURE

Pour réaliser des nanocristaux de semi-conducteur, c'est-à-dire des agrégats de semi-conducteur dont les dimensions peuvent être comprises entre environ quelques nanomètres et quelques centaines de nanomètres, il est connu de réaliser un démouillage d'une couche mince de silicium disposée sur une couche de SiO₂. En effet, lorsque la couche mince de silicium, correspondant par exemple à la couche active, ou couche supérieure, d'un substrat SOI (silicium sur isolant), est soumise à un recuit à haute température (par exemple comprise entre environ 650°C et 1250°C), le silicium de cette couche mince se rétracte progressivement sur lui-même en formant des nanocristaux, ou agrégats, de silicium.

Le document « Agglomération process in thin-silicon-, strained silicon-, and silicon germanium-on-insulator substrates » de G. Capellini et al., Journal of applied physics, vol. 105, 2009, décrit que le démouillage peut être influencé selon que l'on utilise une couche de semi-conducteur contraint de manière bi-axiale ou non contraint. Plus la contrainte bi-axiale à laquelle est soumis le semi-conducteur est importante et/ou plus la couche de semi-conducteur est mince, plus la taille des nanocristaux de semi-conducteur formés par démouillage sera réduite et plus la densité des nanocristaux sera importante. En augmentant la valeur de la contrainte bi-axiale, il est possible de réduire les dimensions des nanocristaux, dans le plan de la couche de semi-conducteur, jusqu'à environ 145 nm. Un autre document montrant la formation de nanocristaux par démouillage d'une couche mince en silicium sur isolant est l'article intitulé ≪Surface-energy driven dewetting theory of silicon-on-insulator agglomeration≫ de D. Danielson et. al., Journal of applied physics, vol. 100, 2006.

Une couche de semi-conducteur contrainte de manière bi-axiale est par exemple obtenue en réalisant une hétéro-épitaxie d'un matériau monocristallin sur un substrat cristallin caractérisé par différentes tailles cristallographiques.

Les nanocristaux formés par démouillage d'une couche mince de semi-conducteur contrainte bi-axialement ont soit une forme sensiblement carré (cette forme correspond à la section des nanocristaux dans un plan par exemple parallèle à l'une des faces principales de la couche de semi-conducteur), soit une forme sensiblement rectangulaire (ou plus généralement une forme allongée, c'est-à-dire comprenant une première dimension perpendiculaire à une seconde dimension, la première dimension étant supérieure à la seconde dimension), en fonction du rapport entre l'énergie de surface et l'énergie élastique initiale du matériau semi-conducteur. Les nanocristaux de semi-conducteur de forme allongée sont orientés aléatoirement selon l'une des directions cristallographiques caractéristiques du substrat.

Ne pas pouvoir choisir l'orientation des nanocristaux de semi-conducteur de forme allongée peut poser des problèmes, par exemple lorsque les nanocristaux sont destinés à faire partie de nano-dispositifs électroniques et que ces nanocristaux doivent être à une distance contrôlée d'autres éléments tels que des électrodes des nano-dispositifs.

### EXPOSÉ DE L'INVENTION

Un but de la présente invention est de proposer un procédé de réalisation de nanocristaux de semi-conducteur permettant de contrôler non seulement les dimensions et la densité des nanocristaux de semi-conducteur, mais également l'orientation de ces nanocristaux de semi-conducteur réalisés par démouillage de semi-conducteur, quelque soit la nature (amorphe ou cristalline) du matériau sous-jacent au semi-conducteur.

Pour cela, la présente invention propose un procédé de réalisation de nanocristaux de semi-conducteur, comportant au moins les étapes de :
- réalisation d'un empilement d'au moins une couche mince, d'épaisseur inférieure ou égale à environ 1 µm, de semi-conducteur contrainte de manière uni-axiale sur une couche diélectrique,
- recuit de la couche mince de semi-conducteur tel qu'un démouillage du semi-conducteur forme, sur la couche diélectrique, des nanocristaux de semi-conducteur de forme allongée orientés perpendiculairement à l'axe de la contrainte.

Du fait de la contrainte uni-axiale s'exerçant sur la couche mince de semi-conducteur, le démouillage du semi-conducteur conduit à des nanocristaux de semi-conducteur compte tenu de la contrainte élastique s'exerçant sur le semi-conducteur au cours du démouillage. De plus, en choisissant l'intensité de la contrainte, on peut moduler les dimensions et la densité des nanocristaux de semi-conducteur formés. Du fait de cette contrainte uni-axiale, la majorité des nanocristaux de semi-conducteur formés par le recuit ont une forme allongée orientés perpendiculairement à l'axe de la contrainte.

Le terme « couche mince » désigne ici et dans tout le reste du présent document une couche de matériau d'épaisseur inférieure ou égale à environ 1 µm, ou inférieure ou égale à environ 100 nm. L'épaisseur de la couche mince utilisée peut être choisie en fonction de l'intensité de la contrainte souhaitée : plus la couche mince sera contrainte, plus l'épaisseur de la couche mince sera réduite. L'épaisseur de la couche mince de semi-conducteur sera inférieure à l'épaisseur critique à partir de laquelle la couche mince de semi-conducteur relaxe plastiquement par émission de dislocations.

De plus, la contrainte qualifiée d'uni-axiale correspond au cas où la contrainte ne s'exerce sur le semi-conducteur que dans une seule direction, mais également au cas où la contrainte s'exerce principalement sur le semi-conducteur selon une direction avec une intensité au moins deux fois supérieure, et de préférence au moins dix fois supérieure, aux intensités des éventuelles autres contraintes s'exerçant sur le semi-conducteur selon les autres directions.

La couche diélectrique peut être contrainte et être disposée entre la couche mince de semi-conducteur et une couche support, la mise sous contrainte de la couche mince de semi-conducteur étant obtenue en gravant au moins partiellement la couche diélectrique selon un motif tel que la contrainte s'exerçant sur la couche diélectrique gravée soit uni-axiale. La contrainte perpendiculaire aux flancs de gravure peut être relaxée dans la couche diélectrique précontrainte en induisant une contrainte dans la couche mince de semi-conducteur dans cette même direction mais de signe opposé à la contrainte initiale de la couche diélectrique. Si la couche diélectrique est en tension (contrainte positive), la couche mince de semi-conducteur peut être contrainte en compression (contrainte négative), et réciproquement.

La couche mince de semi-conducteur contrainte de manière uni-axiale peut être disposée sur plusieurs couches de matériaux comprenant au moins une couche précontrainte, par exemple plusieurs couches de matériaux diélectriques dont au moins l'une est précontrainte, et/ou une ou plusieurs couches de matériaux semi-conducteurs.

L'empilement comprenant la couche mince de semi-conducteur contrainte peut comporter par exemple :
- un substrat, ou couche support, par exemple composé de silicium,
- un alliage de silicium et de germanium déposé par épitaxie sur le substrat, qui est alors naturellement contraint de façon bi-axiale du fait de sa différence de paramètres de maille par rapport au substrat de silicium,
- une couche diélectrique formant une interface entre l'alliage de silicium et de germanium et la couche mince de semi-conducteur, et pouvant servir également d'isolant électrique entre la couche mince de semi-conducteur et l'alliage de silicium et de germanium.

La valeur de l'intensité de la contrainte uni-axiale peut être choisie en fonction des dimensions et de la densité souhaitées des nanocristaux de semi-conducteur.

Le recuit de la couche mince de semi-conducteur peut être réalisé à une température comprise entre environ 650°C et 1250°C, et de préférence entre environ 700°C et 1000°C, et dans un environnement sous ultravide, c'est-à-dire à une pression comprise entre environ 10⁻⁷ mbar et 10⁻¹² mbar. Le recuit peut également être réalisé sous atmosphère hydrogénée.

Le recuit de la couche mince de semi-conducteur peut être mis en oeuvre dans un microscope électronique à balayage ou dans une chambre de recuit en ambiance contrôlée (qui permet d'obtenir les températures et pressions indiquées ci-dessus).

L'invention concerne également un procédé de réalisation d'un couche diélectrique poreuse, comportant au moins la mise en oeuvre d'un procédé de réalisation de nanocristaux de semi-conducteur tel que décrit ci-dessus, dans lequel le recuit de la couche mince de semi-conducteur est prolongé jusqu'à ce que les nanocristaux de semi-conducteur réagissent chimiquement avec la couche diélectrique en formant une pluralité de pores traversant la couche diélectrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3B représentent les étapes d'un procédé de réalisation de nanocristaux de semi-conducteur, objet de la présente invention,
- la figure 4 représente une couche diélectrique poreuse obtenue en poursuivant le recuit réalisé lors d'un procédé de réalisation de nanocristaux de semi-conducteur, objet de la présente invention,
- les figures 5 à 8 représentent plusieurs utilisations possibles d'une couche diélectrique poreuse obtenue en poursuivant le recuit réalisé lors d'un procédé de réalisation de nanocristaux de semi-conducteur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

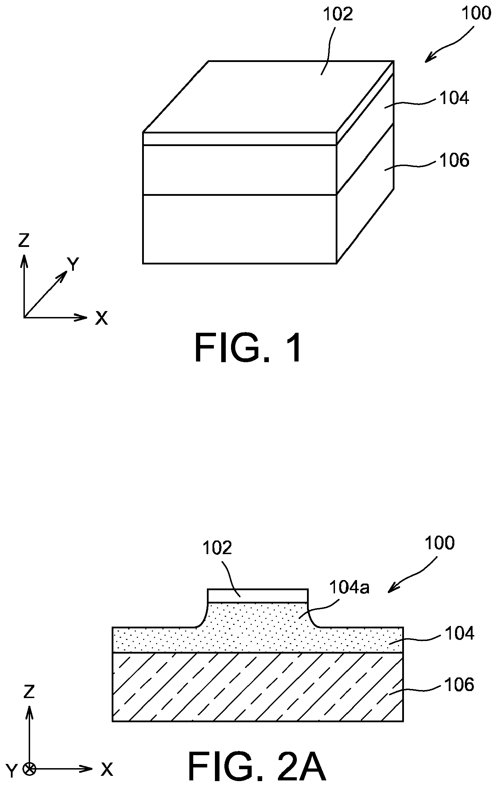

On décrit, en liaison avec les figures 1 à 3B les étapes d'un procédé de réalisation de nanocristaux de semi-conducteur selon un mode de réalisation particulier.

Le procédé de réalisation de nanocristaux de semi-conducteur est mis en oeuvre à partir d'un substrat SOI 100 (représenté sur la figure 1) comprenant une couche mince, c'est-à-dire d'épaisseur inférieure ou égale à environ 1 µm, de silicium monocristallin 102, d'orientation cristalline (001), recouvrant une couche diélectrique 104 enterrée à base de SiO₂ qui repose sur une couche épaisse de silicium monocristallin 106 formant la couche support du substrat 100. La couche mince de silicium 102 a une épaisseur par exemple égale à environ 11 nm.

De manière générale, la couche diélectrique 104 sur laquelle est disposée la couche mince de semi-conducteur 102 peut correspondre à une couche ou à un empilement de plusieurs couches, à base de SiO₂ et/ou de Si₃N₄ et/ou de SiₓN_{y} (nitrure de silicium non stoechiométrique) et/ou de SiₓO_{y}N_{z} et/ou de tout autre matériau diélectrique, cristallin ou amorphe.

La couche diélectrique 104 peut être précontrainte. Dans ce cas, le matériau diélectrique est de préférence composé de nitrure de silicium ou d'oxynitrure de silicium. La contrainte dépend du mode de dépôt utilisé pour former le matériau diélectrique, et peut être une contrainte en compression ou en tension. Dans le cas d'une couche diélectrique 104 composée d'un matériau précontraint cristallin, la précontrainte peut être induite par la différence de paramètre de maille entre le matériau cristallin et le matériau de la couche support 106. Cette précontrainte peut également être induite par la différence de coefficient de dilatation entre la couche support 106 et l'un des matériaux déposé à une température différente de la température de recuit lors de l'étape ultérieure de démouillage.

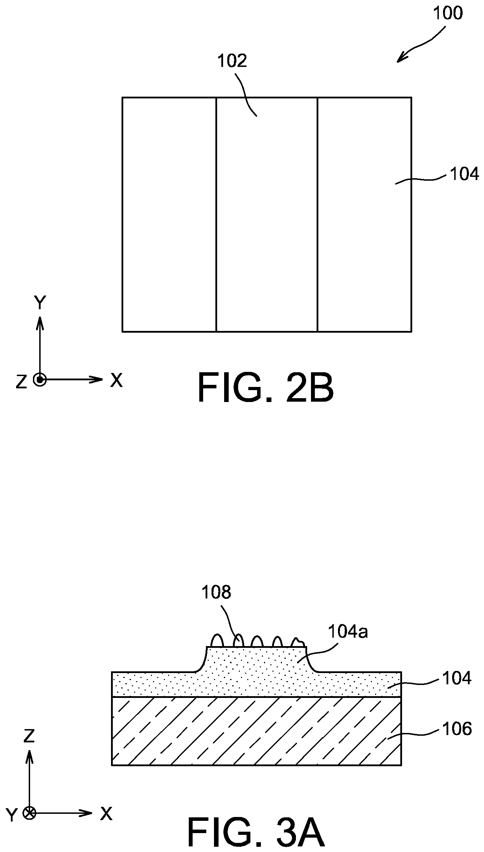

On souhaite contraindre de manière uni-axiale le semi-conducteur de la couche mince 102, c'est-à-dire que le matériau semi-conducteur soit soumis à une force orientée selon une seule direction (ici parallèlement à l'axe X), ou soumis à une force orientée principalement selon cette direction avec une intensité au moins deux fois, et de préférence au moins dix fois, supérieure aux intensités des éventuelles autres contraintes s'exerçant sur le semi-conducteur selon les autres directions. Pour obtenir cette contrainte uni-axiale, la couche diélectrique 104 est gravée sur toute son épaisseur ou, comme sur l'exemple décrit ici, partiellement en formant, contre la couche mince 102, une portion de matériau 104a rectangulaire telle que l'une de ses dimensions, dans le plan (X,Y), c'est-à-dire un plan parallèle aux faces principales des couches du substrat 100, soit supérieure, et par exemple au moins dix fois supérieure, à une autre de ses dimensions dans le plan (X,Y). Sur l'exemple des figures 2A et 2B qui représentent respectivement une vue en coupe de profil et une vue de dessus du substrat 100, la couche 104 est gravée en formant une portion 104a de section (dans le plan (X,Y)) sensiblement rectangulaire dont la dimension selon l'axe Y est supérieure à au moins 10 fois la dimension selon l'axe X. Ainsi, la portion 104a forme une portion de matériau diélectrique contrainte uni-axialement selon l'axe X.

Préalablement à la gravure de la couche diélectrique 104, la couche mince de semi-conducteur 102 est gravée selon un motif similaire à celui de la portion 104a de la couche diélectrique 104 afin que la couche mince de semi-conducteur 102 soit contrainte uni-axialement (selon l'axe X sur l'exemple des figures 2A et 2B). Lors de la gravure de la couche diélectrique 104, le masque utilisé pour la gravure de la couche mince de semi-conducteur 102 peut être conservé, ou retiré selon la sélectivité de gravure du matériau diélectrique par rapport au matériau semi-conducteur de la couche mince 102. Si le masque est retiré, le motif formé par la couche mince 102 gravée sert de masque lors de la gravure de la couche diélectrique 104.

La couche mince 102 devient donc contrainte du fait de la relaxation de la couche 104 perpendiculairement aux flancs de gravure. La couche mince 102 est donc le lieu où s'exerce une contrainte de signe opposé au signe de la contrainte initialement présente dans la couche 102 avant gravure.

D'autres détails et variantes pour réaliser la couche mince de semi-conducteur contrainte de manière uni-axiale sont décrits dans le document US 2006/091105 A1.

Le semi-conducteur de la couche mince 102 peut être un autre semi-conducteur que du silicium, par exemple du germanium ou un alliage de silicium et de germanium, ou encore un matériau III-V, par exemple du GaN et/ou de l'AsGa et/ou de l'AlGaN et/ou de l'InGaN.

On réalise ensuite un recuit à haute température (par exemple égale à environ 800°C, ou plus généralement compris entre environ 600°C et 800°C) entraînant tout d'abord la formation, au niveau de la couche mince 102, d'agrégats de semi-conducteur issu de la couche 102 (agrégats de Sic, c'est-à-dire de carbure de silicium lorsque la couche mince 102 est composée de silicium, ou plus généralement des agrégats de carbure de semi-conducteur). Ces agrégats se forment en raison de la pollution carbonée présente en surface de la couche mince 102, le recuit décomposant les impuretés formant cette pollution. Si la surface de la couche mince 102 est propre, exempt de pollution carbonée, on peut alors ne pas réaliser cette formation d'agrégats.

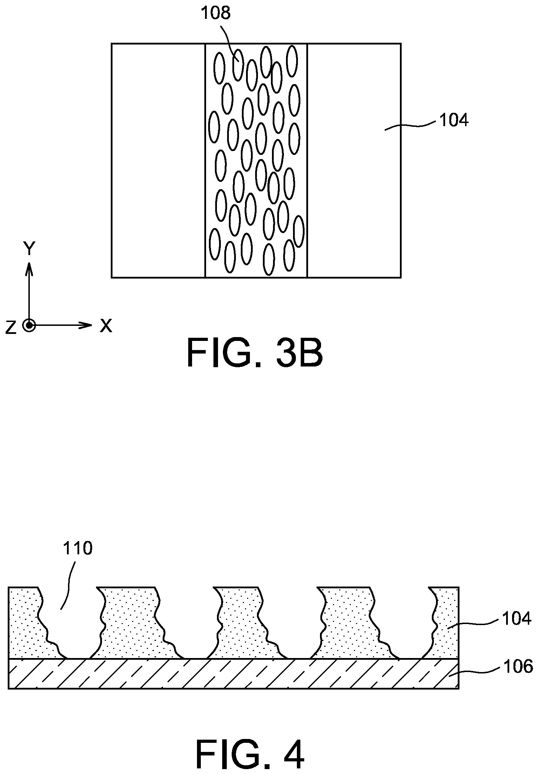

Le recuit est poursuivit à une température par exemple égale à 800°C (similaire à la température du recuit formant les agrégats de SiC) ou par exemple comprise entre environ 600°C et 1250°C ou entre 600°C et 800°C, entraînant le démouillage du semi-conducteur de la couche mince 102, formant des nanocristaux de semi-conducteur 108, ici de silicium, sur la couche diélectrique 104, et plus précisément sur la portion 104a de la couche diélectrique 104. La majorité des nanocristaux de silicium 108 ont, dans le plan (X,Y), une section de forme allongée, par exemple sensiblement rectangulaire, tous orientés parallèlement à l'axe Y, c'est-à-dire perpendiculairement à l'axe de la contrainte (voir figures 3A et 3B). Le rapport entre la plus grande et la plus petite dimension d'un des nanocristaux de semi-conducteur 108 est égal à environ 0,7, et peut être compris entre environ 0 et 1, et de préférence entre environ 0,5 et 0,9.

Ainsi, au moins 60 % des nanocristaux sont allongés et orientés perpendiculairement à l'axe de la contrainte. Préférentiellement, par comparaison à un semi-conducteur non-contraint, environ 90 % des nanocristaux ont une forme allongés et sont orientés perpendiculairement à l'axe de la contrainte dans le cas d'un contrainte d'environ 1,6 %, et environ 60 % des nanocristaux ont une forme allongés et sont orientés perpendiculairement à l'axe de la contrainte dans le cas d'un contrainte d'environ 0,8 %.

Le démouillage du silicium d'une couche mince non contrainte et d'épaisseur initiale égale à environ 7 nm forme des nanocristaux de silicium 108 dont la hauteur moyenne peut être comprise entre environ 70 nm et 140 nm et dont la surface (dans le plan(X,Y), mesurée à une distance d'environ 20 nm de la couche diélectrique 104) peut être en moyenne comprise entre environ 14000 et 60000 nm².

Plus la contrainte sur le semi-conducteur de la couche mince 102 est importante, plus les dimensions des nanocristaux de semi-conducteur 108 obtenus par démouillage sont faibles et plus la densité des nanocristaux 108 est grande.

Par exemple, dans le cas d'une couche mince de semi-conducteur non contrainte, la densité des nanocristaux de silicium obtenus est égale à environ 2,6 nanocristaux/µm², la hauteur moyenne de ces nanocristaux étant égale à environ 100 nm et leur surface moyenne mesurée à environ 20 nm de l'interface entre les couches 102 et 104 est égale à environ 39200 nm². A titre de comparaison, dans le cas d'une couche mince de semi-conducteur contrainte bi-axialement avec une déformation équivalente égale à environ 0,76 %, la densité de nanocristaux obtenue est égale à environ 5,6 nanocristaux/µm², la hauteur moyenne de ces nanocristaux étant d'environ 75 nm et leur surface moyenne, mesurée à environ 20 nm de l'interface entre les couches 102 et 104, est égale à environ 28100 nm². Dans le cas d'une couche mince de semi-conducteur contrainte bi-axialement et dont la déformation équivalente est égale à environ 1,15 %, la densité de nanocristaux obtenue est égale à environ 10,1 nanocristaux/µm², la hauteur moyenne de ces nanocristaux étant d'environ 60 nm et leur surface moyenne mesurée à environ 20 nm de l'interface entre les couches 102 et 104 est d'environ 18500 nm². Dans le cas d'une couche mince contrainte bi-axialement et dont la déformation équivalente est égale à environ 1,56 %, la densité de nanocristaux obtenue est égale à environ 17,2 nanocristaux/µm², la hauteur moyenne de ces nanocristaux étant d'environ 45 nm et leur surface moyenne mesurée à environ 20 nm de l'interface entre les couches 102 et 104 étant d'environ 13500 nm².

Le recuit haute température est mis en oeuvre dans un environnement sous vide UHV (« Ultra High Vacuum »), c'est-à-dire sous ultravide (pression comprise entre environ 10⁻⁷ mbar et 10⁻¹² mbar), par exemple à une pression égale à environ 10⁻⁹ mbar. Ce recuit est par exemple mis en oeuvre dans un bâti de recuit sous atmosphère contrôlée ou au sein d'un microscope électronique à balayage (MEB) ou d'un microscope à force atomique (AFM), tel qu'un microscope du type Veeco Dimension 3100, ou au sein d'un bâti connecté à la chambre d'un de ces équipements. Le recuit est réalisé à une température comprise entre environ 700°C et 1000°C, et par exemple à une température égale à environ 800°C +/- 10°C, pendant une durée comprise entre quelques minutes et quelques dizaines de minutes (par exemple 10 minutes) .

Du fait que la cinétique du démouillage soit commandée par diffusion de surface, plus la température du recuit sera élevée, plus la durée du recuit permettant de réaliser le démouillage du semi-conducteur de la couche mince 102 sera courte.

Les nanocristaux de semi-conducteur 108 formés sur la couche diélectrique 104 peuvent servir ensuite à réaliser des dispositifs électroniques de dimensions nanométriques, tels que les dispositifs mémoires dans lesquels les zones actives électriques correspondent aux nanocristaux 108. Les nanocristaux de semi-conducteur 108 peuvent aussi être utilisés comme éléments émetteurs lumineux en mettant à profit leur photoluminescence, par exemple pour la réalisation de dispositifs de type LED (Light Emitting Diode).

Le recuit peut être réalisé jusqu'à ce que la totalité du semi-conducteur de la couche mince soit démouillé et forme les nanocristaux 108. En prolongeant le recuit (ou un commençant, après le démouillage, un autre recuit) après le démouillage de la totalité du semi-conducteur, et du fait de la haute température, les nanocristaux de silicium 108 réagissent avec le matériau de la couche diélectrique 104. Dans l'exemple décrit ici, on a la réaction : SiO₂ + Si -> 2 SiO. Du fait que le SiO s'évapore, le silicium forme alors au travers de la couche diélectrique 104 des trous 110 tels que représentés sur la figure 4. La réaction se produisant entre les nanocristaux de semi-conducteur 108 et le matériau diélectrique de la couche 104 consume entièrement les nanocristaux 108. Les trous 110 ont une forme particulière due au déplacement en spirales des nanocristaux 108 qui « creusent » le SiO₂ de la couche diélectrique 104. Lorsque les nanocristaux 108 ont une forme allongée avec un facteur de forme inférieur à environ 0,5, les forces capillaires exercées sur l'agrégat peuvent limiter sa liberté de se déplacer selon un mouvement en spiral. Dans ce cas, les trous 110 ont une forme sensiblement conique avec, en surface (surface supérieure de la couche diélectrique 104) une forme proche de la forme de l'agrégat de semi-conducteur après démouillage. Les flancs des trous 110 coniques forment par exemple un angle, par rapport à une direction perpendiculaire à l'interface des couches 104 et 106, compris entre environ 30° et 75°, et généralement compris entre environ 40° et 65°.

Dans l'exemple décrit ici, les trous 110 traversent toute l'épaisseur de la couche diélectrique 104 et débouchent sur la couche épaisse de silicium 106.

Du fait que le procédé décrit permet de contrôler les dimensions, la densité et l'orientation des nanocristaux de silicium 108, il est donc possible de définir et contrôler les dimensions, la densité et l'orientation des trous 110. La dimension de ces trous 110 au niveau de la face supérieure de la couche diélectrique 104 (correspondant initialement à l'interface entre les couches 102 et 104) est comprise entre environ 1 et 5 fois le diamètre des nanocristaux de semi-conducteur 108 initialement formés avant leur réaction avec le matériau diélectrique de la couche 104.

Le procédé de réalisation de nanocristaux de semi-conducteur décrit ici permet donc, en prolongeant la durée du recuit, de réaliser, dans la couche diélectrique, un motif périodique de trous dont l'orientation, la densité et les dimensions sont contrôlables.

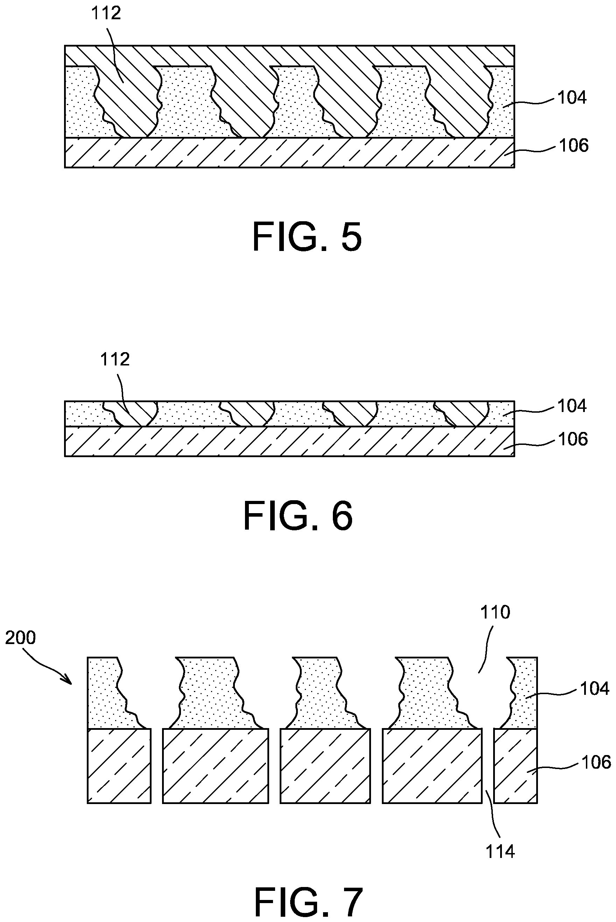

A partir de la couche diélectrique poreuse obtenue, il est possible de réaliser par exemple une matrice de vias conducteurs 112 entre les faces avant et arrière de la couche diélectrique 104. Pour cela, on peut réaliser un dépôt sous vide de métal (figure 5) remplissant les trous 110, puis un polissage afin de supprimer le métal se trouvant sur la face supérieure de la couche diélectrique 104 et dépassant des trous 110. Ce polissage peut également supprimer une partie de l'épaisseur de la couche diélectrique 104 afin de réduire les dimensions dans le plan (X,Y) des vias conducteur 112 (figure 6).

A partir de la couche diélectrique poreuse obtenue, il est possible de réaliser par exemple une matrice de capacités électriques. Pour cela, on dépose tout d'abord une première électrode métallique contre une première face de la couche diélectrique poreuse, puis on dépose un matériau diélectrique dans les pores de la couche diélectrique poreuse, et enfin on dépose une seconde électrode métallique contre une seconde face, opposée à la première face, de la couche diélectrique poreuse. On obtient alors une matrice de capacités diélectriques formées entre les deux électrodes. Pour ce type d'application, une ou plusieurs étapes de masquage / gravure peuvent être réalisées afin d'assurer la reprise de contact électrique sur la première électrode à travers l'empilement de couches réalisé.

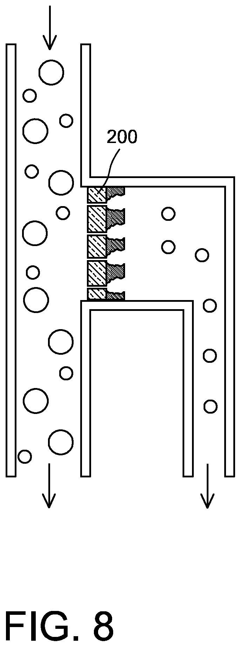

Dans un autre mode de réalisation, la couche diélectrique 104 poreuse obtenue peut servir de membrane microporeuse. Pour cela, la couche épaisse de silicium 106 peut être gravée telle que des trous 114, se trouvant à l'aplomb des trous 110 traversant la couche diélectrique 104, traversent toute l'épaisseur de la couche de silicium 106 (voir figure 7). On obtient ainsi une membrane poreuse 200 pouvant servir par exemple de filtre apte à séparer des molécules liquides ou gazeuses, comme représenté sur la figure 8.

Cette membrane poreuse 200 peut également servir dans le domaine du diagnostic, des molécules biologiques pouvant être déposées dans les trous, la membrane servant alors de détecteur.

Il est possible d'interrompre le recuit avant que les trous 110 ne débouchent sur l'interface entre les couches 104 et 106. Dans ce cas, on retrouve au fond des trous 110 les nanocristaux de semi-conducteur partiellement consumés (en raison de la réaction du semi-conducteur des nanocristaux avec le diélectrique de la couche 104) . Du fait qu'ils sont partiellement consumés, les dimensions de ces nanocristaux sont réduites par rapport aux dimensions initiales des nanocristaux. Ces dimensions peuvent varier entre 0 (cas où les nanocristaux sont totalement consumés) et les dimensions quasi-initiales des nanocristaux (dans le cas de trous de très faible profondeur) . Les trous 110 peuvent ensuite être rebouchés, par exemple par un dépôt d'oxyde de silicium. Lorsque des nanocristaux de semi-conducteur résiduels sont présents au fond des trous et après une étape de dépôt d'un matériau diélectrique comblant les trous précédemment formés, on obtient dans ce cas des nanocristaux enterrés au sein d'une couche diélectrique.

Une telle structure peut également être obtenue à partir d'une couche diélectrique 104 comprenant un empilement de différents matériaux diélectriques, par exemple un bicouche SiO₂ / Si₃N₄ ou SiO₂ /SiₓO_{y}N_{z}, ou tout autre empilement comprenant au moins deux matériaux diélectriques dont les cinétiques de réaction avec le semi-conducteur des nanocristaux sont différentes (la cinétique de réaction du matériau de la couche inférieure étant choisie beaucoup plus faible que celle du matériau de la couche supérieure par exemple composée de SiO₂). Dans ce cas, pour une couche diélectrique 104 correspondant par exemple à un bicouche SiO₂ / Si₃N₄, les trous 110 se forment dans le SiO₂ et l'interface entre le SiO₂ et le Si₃N₄ sous-jacent forme un lieu d'arrêt naturel des nanocristaux de silicium. La position finale des nanocristaux de semi-conducteur résiduels au sein de la couche diélectrique 104 peut donc être contrôlée par l'épaisseur de la couche de SiO₂. Comme précédemment, les trous formés dans SiO₂ peuvent être comblés par un dépôt d'un matériau, par exemple du SiO₂.

Il est également possible de prévoir l'épaisseur de la couche diélectrique 104 et les dimensions des nanocristaux de semi-conducteur telles que des nanocristaux de semi-conducteur résiduels sont présents après avoir traversés la totalité de l'épaisseur de la couche diélectrique 104, ces nanocristaux résiduels reposant dans ce cas sur la couche épaisse 106.

## Revendications

1. Procédé de réalisation de nanocristaux de semi-conducteur (108), comportant au moins les étapes de :
- réalisation d'un empilement d'au moins une couche mince d'épaisseur inférieure ou égale à environ 1 µm de semi-conducteur (102) contrainte de manière uni-axiale sur une couche diélectrique (104),
- recuit de la couche mince de semi-conducteur (102) tel qu'un démouillage du semi-conducteur forme, sur la couche diélectrique (104), des nanocristaux de semi-conducteur (108) de forme allongée orientés perpendiculairement à l'axe de la contrainte.

2. Procédé selon la revendication 1, dans lequel la couche diélectrique (104) est contrainte et est disposée entre la couche mince de semi-conducteur (102) et une couche support (106), la mise sous contrainte de la couche mince de semi-conducteur (102) étant obtenue en gravant au moins partiellement la couche diélectrique (104) selon un motif tel que la contrainte s'exerçant sur la couche diélectrique (104) gravée soit uni-axiale.

3. Procédé selon l'une des revendications précédentes, dans lequel la valeur de l'intensité de la contrainte uni-axiale est choisie en fonction des dimensions et de la densité souhaitées des nanocristaux de semi-conducteur (108).

4. Procédé selon l'une des revendications précédentes, dans lequel le recuit de la couche mince de semi-conducteur (102) est réalisé à une température comprise entre environ 700°C et 1000°C et dans un environnement sous ultravide.

5. Procédé selon l'une des revendications précédentes, dans lequel le recuit de la couche mince de semi-conducteur (102) est mis en oeuvre dans un microscope électronique à balayage ou dans une chambre de recuit en ambiance contrôlée.

6. Procédé de réalisation d'un couche diélectrique poreuse, comportant au moins la mise en oeuvre d'un procédé de réalisation de nanocristaux de semi-conducteur (108) selon l'une des revendications précédentes dans lequel le recuit de la couche mince de semi-conducteur (102) est prolongé jusqu'à ce que les nanocristaux de semi-conducteur (108) réagissent chimiquement avec la couche diélectrique (104) en formant une pluralité de pores (110) traversant la couche diélectrique (104).

## Patentansprüche

1. Verfahren zur Herstellung von Halbleiternanokristallen (108), umfassend wenigstens die folgenden Schritte:
- Herstellen eines Stapels von wenigstens einer dünnen Schicht mit einer Dicke kleiner oder gleich ungefähr 1 µm aus einem Halbleiter (102), der in uniaxialer Weise gespannt ist, auf einer dielektrischen Schicht (104),
- Tempern der dünnen Halbleiterschicht (102) derart, dass eine Entfeuchtung des Halbleiters auf der dielektrischen Schicht (104) Halbleiternanokristalle (108) mit länglicher Form bildet, die orthogonal zur Achse der Spannung orientiert sind.

2. Verfahren nach Anspruch 1, bei dem die dielektrische Schicht (104) gespannt ist und zwischen der dünnen Halbleiterschicht (102) und einer Trägerschicht (106) angeordnet ist, wobei das unter Spannung Setzen der dünnen Halbleiterschicht (102) erzielt wird, indem man die dielektrische Schicht (104) wenigstens teilweise mit einem Motiv derart ätzt, dass die Spannung, die auf die geätzte dielektrische Schicht (104) ausgeübt wird, uniaxial ist.

3. Verfahren nach einem der vorhergehenden Ansprüche, bei dem der Wert der Intensität der uniaxialen Spannung als Funktion der gewünschten Dimensionen und der Dichte der Halbleiternanokristalle (108) gewählt wird.

4. Verfahren nach einem der vorhergehenden Ansprüche, bei dem das Tempern der dünnen Halbleiterschicht (102) bei einer Temperatur durchgeführt wird, die zwischen ungefähr 700°C und 1000°C enthalten ist, und bei einer Umgebung unter Ultrahochvakuum.

5. Verfahren nach einem der vorhergehenden Ansprüche, bei dem das Tempern der dünnen Halbleiterschicht (102) in einem elektronischen Rastermikroskop oder in einer Temperkammer in einer kontrollierten Atmosphäre durchgeführt wird.

6. Verfahren zur Herstellung einer porösen dielektrischen Schicht, umfassend wenigstens die Durchführung eines Verfahrens zur Herstellung von Halbleiternanokristallen (108) nach einem der vorhergehenden Ansprüche, bei dem das Tempern der dünnen Halbleiterschicht (102) fortgesetzt wird, bis die Halbleiternanokristalle (108) chemisch mit der dielektrischen Schicht (104) unter Bildung einer Mehrzahl von Poren (110) reagieren, die die dielektrische Schicht (104) durchsetzen.

## Claims

1. A method for making semiconductor nanocrystals (108), including at least the steps of:
- making a stack of at least one uniaxially stressed semiconductor thin layer (102) having a thickness less than or equal to around 1 µm on a dielectric layer (104),
- annealing the semiconductor thin layer (102) such that a dewetting of the semiconductor forms, on the dielectric layer (104), elongated shaped semiconductor nanocrystals (108) oriented perpendicularly to the stress axis.

2. The method according to claim 1, wherein the dielectric layer (104) is stressed and is provided between the semiconductor thin layer (102) and a support layer (106), the stressing of the semiconductor thin layer (102) being achieved by etching at least partially the dielectric layer (104) according to a pattern such that the stress exerted on the etched dielectric layer (104) is uniaxial.

3. The method according to one of previous claims, wherein the intensity value of the uniaxial stress is selected as a function of the desired dimensions and density of the semi-conductor nanocrystals (108).

4. The method according to one of previous claims, wherein the annealing of the semi-conductor thin layer (102) is performed at a temperature between about 700°C and 1000°C and under a ultra-high vacuum environment.

5. The method according to one of previous claims, wherein the annealing of the semiconductor thin layer (102) is implemented in a scanning electron microscope or in a controlled environment annealing chamber.

6. A method for making a porous dielectric layer, including at least the implementation of a method for making semiconductor nanocrystals (108) according to one of previous claims, wherein the annealing of the semiconductor thin layer (102) is prolonged until the semiconductor nanocrystals (108) chemically react with the dielectric layer (104) forming a plurality of holes (110) passing through the dielectric layer (104).
